# EUROPÄISCHE PATENTSCHRIFT

(11) **EP 1 935 092 B1**
(45) Veröffentlichungstag und Bekanntmachung des Hinweises auf die Patenterteilung: **22.04.2009**
(21) Anmeldenummer: 06807016.8
(22) Anmeldetag: 05.10.2006
(51) Int. Cl.: H03G 3/30

(54) **EMPFÄNGERSCHALTUNG FÜR EIN NACHRICHTENTECHNISCHES EMPFANGSGERÄT**
RECEIVING CIRCUIT FOR AN INFORMATION ENGINEERING RECEIVING DEVICE
CIRCUIT DE RECEPTION UTILISE UN APPAREIL DE RECEPTION UTILISE DANS LE DOMAINE DE L'INFORMATION

(30) Priorität: 05.10.2005 DE 102005047588
(43) Veröffentlichungstag der Anmeldung: 25.06.2008
(73) Patentinhaber: LOEWE OPTA GmbH, 96317 Kronach (DE)
(72) Erfinder: ZISKA, Thomas, 96268 Mitwitz (DE)
(74) Vertreter: Kinnstätter, Klaus
(86) Internationale Anmeldenummer: PCT/EP2006/067112
(87) Internationale Veröffentlichungsnummer: WO 2007/039640

(56) Entgegenhaltungen:
- WO-A-20/05009034
- DE-A1- 10 158 274
- US-A1- 2005 009 483

## Beschreibung

Die Erfindung betrifft eine Empfängerschaltung für ein nachrichtentechnisches Empfangsgerät, insbesondere für ein Fernsehgerät, welches zumindest einen HF-Verstärker zur einstellbaren Verstärkung eines Rundfunksignals, einen Tuner und eine ZF-Stufe mit den im Oberbegriff des Anspruchs 1 angegebenen Merkmale aufweist und ein korrespondierendes Verfahren hierfür.

Aus der DE 101 58 274 A1 ist ein Verfahren zum Bestimmen der Signalstärke eines Signals am Eingang eines Tuners bekannt, bei dem die frequenzabhängige Verstärkungskennlinie des Tuners gemessen und in einem dem Tuner zugeordneten Speicher abgelegt wird. Mit Hilfe dieser Kennlinie kann beim Betrieb des Tuners die frequenzabhängige Variation der Verstärkung kompensiert werden, um präziser auf die Stärke des Eingangssignals rückschließen zu können. Bei einem Tuner mit automatischer Verstärkungsregelung (AGC) kann zusätzlich die Frequenzabhängigkeit (AGC) erfasst und im Speicher durch repräsentative Kennlinien abgelegt werden. Durch die Berücksichtigung der AGC-Kennlinie ergibt sich eine weitere Verbesserung der Genauigkeit bei der Abschätzung der Signalstärke des Eingangssignals.

Ferner ist eine Schaltungsanordnung in einem Empfänger für digitale Fernsehsignale aus der EP 1 267 488 A2 mit einem Tuner bekannt, die eine automatische Justierung des Übergabepunktes für die automatische Verstärkungsregelung ermöglicht. Aus der US 2002/0131533 A1 ist ein Demodulator in einer Empfängerschaltung bekannt, von der eine AGC-Spannung sowohl für die Regelung eines Vorverstärkers in dem Tuner als auch für den ZF-Verstärker abgeleitet wird, um einen verbesserten Empfang zu ermöglichen.

Aus der internationalen Offenlegungsschrift WO 2005/009034 A1 ist eine Vorrichtung und ein Verfahren zur Bereitstellung einer automatischen Verstärkungsregelfunktion (AGC) auf Basis einer vielfachen Rückkopplung von Signalen bekannt, welche engbandige und weitbandige AGC-Signale in adaptiver Art und Weise bereitstellen. Nach einer dortigen Ausführungsform weist die Vorrichtung einen Tuner auf, welcher zur Erzeugung von ersten und zweiten ZF-Signalen ausgebildet ist. Ein erster Demodulator ist dazu ausgebildet, ein erstes AGC-Signal als Reaktion auf das erste ZF-Signal zu erzeugen. Ein zweiter Demodulator ist dazu ausgebildet, ein zweites AGC-Signal als Reaktion auf ein zweites ZF-Signal zu erzeugen. Es ist ein Weitband-AGC-Detektor dazu ausgebildet, dritte AGC-Signale als Reaktion mindestens auf das erste und zweite ZF-Signal zu erzeugen. Ein Schalter ist dazu ausgelegt, den Tuner eines der ersten, zweiten oder dritten AGC-Signale in Reaktion auf eine vorbestimmte Bedingung bereitzustellen. Die automatische Verstärkungsregelfunktion wird über einen zentralen Prozessor gesteuert, wobei die ZF-Stufen lediglich AGC-Signale liefern.

Der Tuner und die ZF-Stufe einer bekannten Empfängerschaltung weisen je eine mit dem zumindest einen HF-Verstärker verbundene automatische Verstärkungsregeleinheit auf. Von der ZF-Stufe ist ein Übernahmesignal an den Tuner zur Übernahme der Verstärkungsregelung ausgebbar. Vom Tuner ist ein ZF-Signal mit einem vorgebbaren Pegelbegrenzungswert erzeugbar. Die Erfindung betrifft ein nachrichtentechnisches Empfangsgerät, insbesondere ein Fernsehgerät, welches eine solche Empfängerschaltung aufweist. Schließlich betrifft die Erfindung ein Verfahren zum Abgleich einer automatischen Verstärkungsregeleinheit einer ZF-Stufe einer Empfangsschaltung für ein nachrichtentechnisches Empfangsgerät, wobei die ZF-Stufe einem Tuner mit einer weiteren automatischen Verstärkungsregeleinheit nachgeschaltet ist. Die ZF-Stufe kann ein Übernahmesignal an den Tuner zur Übernahme der Verstärkungsregelung ausgeben. Der Tuner erzeugt aus einem Rundfunksignal ein ZF-Signal mit einem vorgebbaren Pegelbegrenzungswert.

Eine Empfängerschaltung ist dazu vorgesehen, ein HF-Rundfunksignal, insbesondere ein Fernseh- oder TV-Signal, kanalbezogen zu demodulieren und so aufzubereiten, dass es auf einer Anzeigeeinheit dargestellt oder aufgezeichnet werden kann. Vorzugsweise ist eine Empfängerschaltung in einem Fernsehgerät als nachrichtentechnisches Empfangsgerät untergebracht.

Das Rundfunksignal wird üblicherweise nach einer Kette von HF-Filterstufen mittels eines HF-Verstärkers verstärkt und dann einem Tuner zugeführt. Im Tuner erfolgt die Erzeugung eines Zwischenfrequenz- oder ZF-Signals eines ausgewählten Fernsehkanals. Die Erzeugung der Zwischenfrequenz erfolgt mittels eines oder mehrerer Mischer, deren Filterfrequenz auf den vom Benutzer gewünschten Kanal eingestellt werden kann. Die Einstellung der Frequenz erfolgt üblicherweise mittels einer PLL-Schleife mit spannungsgesteuerten Oszillatoren (VCO) und in ihrem Teilungsverhältnis einstellbaren Teilerstufen. Das ZF-Signal wird dann typischerweise durch eine nachgeschaltete OFW-Filtergruppe spektral in Teilfrequenzbereiche aufgeteilt, die z.B. das Helligkeitssignal, das Farbsignal und das Tonsignal aufweisen. Eine nachfolgende ZF-Stufe bereitet die vorgefilterten Signale so auf, dass ausgangsseitig ein FBAS-Signal oder CVS-Signal (Composite Video Signal), die Mono- oder Stereoaudiosignale, Datensignale oder z.B. auch ein sogenanntes SSIF-Signal (Second Sound Intermediate Frequency) zur Verfügung stehen. Diese Signale können nachfolgend aufgezeichnet oder durch eine Bild- und Tonausgabeeinheit auf einem Bildschirm zur Anzeige gebracht werden.

Häufig verfügt die ZF-Stufe über eine automatische Verstärkungsregeleinheit in bereits integrierter Form, die in der Fachsprache auch als AGC (Automatic Gain Control) bezeichnet wird. Dabei wird die Verstärkung in einer Regelschleife mit den HF-Verstärkern auf einen vorgebbaren konstanten Wert geregelt, so dass das zu verarbeitende ZF-Signal einen nahezu konstanten Signalpegel aufweist. Auf diese Weise werden eingangsseitige Signalschwankungen in der Übertragungskette ausgeglichen. Bei den HF-Verstärkern handelt es sich z.B. um Dual-Gate-MOSFET-Transistoren, deren Verstärkungsgrad spannungsgesteuert eingestellt werden kann.

Eine ZF-Stufe der zuvor beschriebenen Art ist z.B. von der Fa. Philips unter der Typenbezeichnung TDA9899HL oder TDA9899HN erhältlich. Ein solcher integrierter Baustein weist zumeist auch eine serielle Schnittstelle, wie z.B. eine I²C-Schnittstelle, auf, über welche Daten an einen übergeordneten Mikrocontroller zur Steuerung des Empfangsgeräts gesendet bzw. Daten über die Schnittstelle empfangen werden können. Bei der zuvor genannten ZF-Stufe kann neben einer Vielzahl von Parametern auch ein sogenannter TOP (Tuner Take Over Point) eingestellt werden, der die Übernahme der Verstärkungsregelung an den vorgeschalteten Tuner signalisiert. Die Einstellung des Tuner Take Over Points erfolgt üblicherweise im Rahmen der Endprüfung einer Fertigung.

Auch der Tuner kann über eine automatische Verstärkungsregeleinheit verfügen, mittels derer die in ihrer Verstärkung einstellbaren HF-Verstärker ausgeregelt werden können. Wenn ein solcher Tuner ein Signal zur Übernahme der Verstärkungsregelung empfängt, wie dies z.B. bei Eingangssignalen ab einem bestimmten Pegel (Take Over Point) der Fall ist, so übernimmt die ZF-Stufe die Regelung. Ein solcher Tuner ist in integrierter Form z.B. von der Fa. Infineon unter der Typenbezeichnung TUA6034 erhältlich und ist mit Verstärkern verbunden, die in Abhängigkeit von der Regelspannung geregelt werden. Der IC verfügt über eine I²C-Schnittstelle, um die Vielzahl der internen Funktionen des Tuners in Form von Parametern, wie z.B. die Mischerfrequenzen, Verstärkungsgrade der AGC etc., einstellen zu können.

Enthält ein von einem Sender empfangenes Rundfunksignal neben analogen Kanälen auch digitale Kanäle, so tritt bei einem Nachbarkanalbetrieb von analogen und digitalen Rundfunkkanälen, insbesondere bei Fernsehkanälen, das Problem auf, dass der Tuner durch den analogen Nachbarkanal übersteuert wird. Die Folge ist, dass das eigentliche Nutzsignal - in diesem Falle das digitale Nutzsignal - nicht mehr empfangen werden kann. Ursache dafür ist, dass die Signale der digitalen Kanäle einen im Vergleich zu den analogen Kanälen um ca. 20 dB reduzierten Pegel aufweisen, so dass in Folge der großen Differenz eine Übersteuerung, z.B. wegen Oszillator Pulling oder dergleichen auftreten kann.

Aus diesem Grund verfügen neuere Tunerbausteine, wie z.B. der oben genannte TUA6034 der Fa. Infineon, über eine Breitband-AGC, d.h. über eine automatische Breitband-Verstärkungsregeleinheit. Eine solche AGC bewertet hinsichtlich der Erzeugung eines geregelten Verstärkersignals für die HF-Verstärker nicht nur die Bandbreite des eigentlichen Kanal, sondern auch Nachbarkanäle (TV-Kanal z.B. 7 oder 8 MHZ).

Für das Zusammenspiel zwischen Tuner und ZF-Stufe ist hinsichtlich der Übernahme der Verstärkungsregelung ein sorgfältiger Abgleich der ZF-Stufe, insbesondere der automatischen Verstärkungsregeleinheit, erforderlich. Dieser Abgleich ist messtechnisch sehr aufwändig und erfordert eine Kalibrierung des Messsignals zur Einspeisung in die Empfängerschaltung. Eine Kalibrierung ist zumindest einmal am Tag notwendig. Da im Rahmen der Fertigung zumeist mehrere Abgleichplätze vorgesehen sind, ist diese Maßnahme an jedem einzelnen Abgleichplatz durchzuführen.

Für den Abgleich musste bisher ein Messsignal mit einem konstanten Pegel, wie z.B. ein Signal mit einem Pegel von 63 dBµV, in die Empfängerschaltung eingespeist werden. Danach konnte der Tunerübernahmepunkt in der ZF-Stufe eingestellt werden, indem ein signifikanter Spannungssprung an einem Monitorausgang der ZF-Stufe ausgewertet wurde. Der zugehörige Wert des Tunerübernahmepunkts wurde dann als Parameter abgespeichert, den der Mikrocontroller nach Einschalten eines Empfangsgeräts wieder aus einem nichtflüchtigen Speicher auslesen und an die ZF-Stufe übertragen konnte. Durch den Abgleich konnte sichergestellt werden, dass das HF-Rundfunksignal nicht übersteuert und zugleich das Signal/Rauschverhältnis nicht zu "schlecht" wurde. Im Rahmen des Abgleichs ist folglich ein Abgleichsfenster zu treffen, welches nur wenige dB umfasst, um einen optimalen Abgleich zu bewerkstelligen.

Es ist somit eine Aufgabe der Erfindung, eine Empfängerschaltung für ein nachrichtentechnisches Empfangsgerät anzugeben, bei welcher der Abgleichvorgang einer automatischen Verstärkungsregelung einer ZF-Stufe erheblich vereinfacht wird.

Es ist eine weitere Aufgabe der Erfindung, ein korrespondierendes Verfahren zum Abgleich einer automatischen Verstärkungsregelung einer ZF-Stufe anzugeben.

Die Aufgabe wird gelöst mit einer Empfängerschaltung mit den im Anspruch 1 angegebenen Merkmalen. Vorteilhafte Ausgestaltungen und Weiterbildungen der Empfängerschaltung ergeben sich aus den abhängigen Ansprüchen 2 bis 8.

In Anspruch 9 ist ein nachrichtentechnisches Empfangsgerät angegeben, welches eine solche Empfängerschaltung aufweist. Das korrespondierende Verfahren ist in Anspruch 10 angegeben. Vorteilhafte Verfahrensschritte ergeben sich aus den abhängigen Ansprüchen 11 bis 13.

Wesentliches Merkmal der Erfindung ist, dass durch entsprechende Programmierung der automatischen Verstärkungsregeleinheit des Tuners ein pegelbegrenztes ZF-Signal als Referenz für die nachfolgende ZF-Stufe erzeugt wird. Dieses pegelbegrenzte ZF-Signal weist einen äußerst stabilen Pegel auf und kann somit vorteilhaft als Referenzsignal zur Einstellung des Tunerübernahmepunkts der ZF-Stufe verwendet werden. Dabei wird die automatische Verstärkungsregeleinheit des Tuners so eingestellt, dass bereits für Pegel des HF-Rundfunksignals ab 60 dBµV, welche üblicherweise in einem Kabelnetz oder von einem Receiver vorliegen, ein pegelbegrenztes ZF-Signal bereitgestellt werden kann.

Der besondere Vorteil ist, dass keine hohen Anforderungen mehr an ein Messsignal zur Einspeisung in eine Empfängerschaltung gestellt werden müssen. Der messtechnische Aufwand reduziert sich erheblich.

In einer besonderen Ausführungsform sind der Tuner und die ZF-Stufe mit einer Steuereinheit verbunden, welche Mittel zur Weiterleitung des Übernahmesignals an den Tuner und Mittel zur Ausgabe eines Tunerübernahmewerts an die ZF-Stufe aufweist, wobei die Steuereinheit den Tunerübernahmewert solange erhöht bzw. erniedrigt, bis ein Wechsel des Übernahmesignals detektierbar ist. Dadurch kann in besonders vorteilhafter Weise der Abgleichsprozess automatisch durchgeführt werden.

Der Abgleichsprozess ist dabei vorteilhaft in einem Bruchteil einer Sekunde abgeschlossen.

Insbesondere liegt der Pegelbegrenzungswert in einem Bereich von 103 dBµV bis 109 dBµV.

Das Übernahmesignal und der Tunerübernahmewert sind gemäß einer weiteren Ausführungsform der Erfindung über eine serielle Schnittstelle, insbesondere über eine I²C-Busschnittstelle, übertragbar. Diese standardisierte Busschnittstelle verbindet alle kommunikationsfähigen Funktionseinheiten eines Empfangsgeräts untereinander.

Im Besonderen sind der Pegelbegrenzungswert und der Tunerübernahmewert in einem elektronischen Speicher, insbesondere in einem nichtflüchtigen EEPROM-Speicher der Steuereinheit, speicherbar. Dadurch können nach einem Einschalten des Empfangsgeräts die zuvor genannten Parameter ausgelesen und über die Schnittstelle an den Tuner und an die ZF-Stufe übertragen werden.

Besonders vorteilhaft ist es, dass der Pegelbegrenzungswert über ein Benutzereingabemittel des Empfangsgeräts eingestellt werden kann. Das Benutzereingabemittel kann z.B. eine Fernbedienung oder ein Tastenfeld des Empfangsgeräts sein. Über dise kann z.B. ein Onscreen-Menue zur Einstellung des Pegelbegrenzungswerts aufgerufen werden. Dadurch kann ein Abgleich von einem Benutzer, d.h. von einem Fernsehzuschauer, sogar von zuhause aus vorgenommen werden. Der Abgleichprozess kann z.B. durch Drücken einer speziellen Taste oder durch Auswahl eines Menuepunkts im Onscreen-Menue erfolgen. Es wird dann mittels der Steuereinheit des Empfangsgeräts automatisch der Tunerübernahmepunkt schrittweise erhöht bzw. erniedrigt, bis das Übernahmesignal der ZF-Stufe detektiert wird. Der zugehörige Wert wird dann in einem nichtflüchtigen Speicher abgelegt.

Die Aufgabe wird weiterhin gelöst durch ein nachrichtentechnisches Empfangsgerät, insbesondere ein Fernsehgerät, welches eine solche Empfängerschaltung gemäß der Erfindung aufweist.

Die Aufgabe wird weiterhin durch ein Verfahren zum Abgleich einer automatischen Verstärkungsregeleinheit einer ZF-Stufe einer Empfangsschaltung für ein nachrichtentechnisches Empfangsgerät gelöst. Die ZF-Stufe ist einem Tuner mit einer weiteren automatischen Verstärkungsregeleinheit nachgeschaltet, wobei die ZF-Stufe ein Übernahmesignal zur Übernahme der Verstärkungsregelung an den Tuner ausgeben kann und wobei der Tuner ein ZF-Signal mit einem vorgebbaren Pegelbegrenzungswert aus einem Rundfunksignal erzeugt. Das pegelbegrenzte ZF-Signal dient dabei als Referenz für den Abgleich.

In entsprechender Weise wird ein Tunerübernahmewert der ZF-Stufe, bei dem die Verstärkerregelung an den Tuner übergeben wird, solange erhöht bzw. verringert, bis ein Wechsel des Übernahmesignals detektiert wird. Insbesondere kann der Tunerübernahmewert von einem Benutzer des Empfangsgeräts eingestellt werden.

Bei einer besonderen Verfahrensvariante kann der Abgleich in vorgebbaren Zeitabständen und/oder bei einem Kanalwechsel automatisch erfolgen. Auf diese Weise braucht der Benutzer des Empfangsgeräts überhaupt keine Maßnahmen zum Abgleich vorzunehmen. Dies erfolgt voll automatisch.

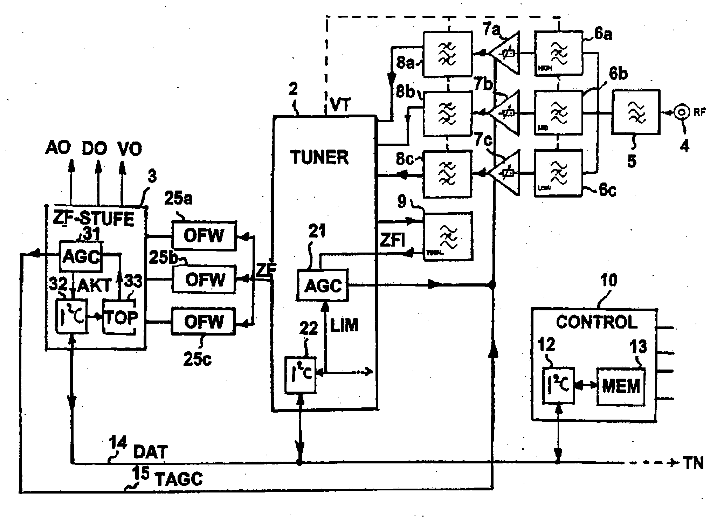

Weitere vorteilhafte Eigenschaften der Erfindung ergeben sich aus deren beispielhafter Erläuterung anhand der einzigen Figur.

Die Figur zeigt ein Prinzipschaltbild der erfindungsgemäßen Empfängerschaltung. Im rechten Teil der Figur ist eine Eingangsbuchse 4 für das HF-Rundfunksignal RF zu sehen, welches nachfolgend mittels eines Hochpasses 5 gefiltert wird. Diese Filterfrequenz kann z.B. 42 MHz betragen. Gemäß dem Beispiel der Figur wird das vorgefilterte HF-Rundfunksignal mittels dreier Vorkreise 6a-6c gefiltert, wobei die Vorkreise 6a-6c einem oberen, mittleren und unteren Frequenzbereich zugeordnet sind. Nach Filterung durch die Vorkreise 6a-6c erfolgt die Verstärkung mit je einem HF-Verstärker 7a-7c. Die HF-Verstärker 7a-7c sind z.B. Dual-Gate-MOSFET-Transistoren und in ihrem Verstärkungsgrad einstellbar. Über eine abstimmbare Bandpassfilterstufe 8a-8c, die auch mehrstufig ausgebildet sein kann, wird der jeweils gewünschte Kanal aus der Vielzahl von Kanälen ausgewählt. Die hierzu notwendigen Oszillatoren sowie die Spulen und Abstimmkreise sind aus Gründen der Übersichtlichkeit nicht dargestellt. Die Bandpassfilterstufe 8a-8c sowie die Vorkreise 6a-6c werden über eine Steuerspannung VT, die vom Tuner erzeugt wird, angesteuert. Über die Steuerspannung VT sind die entsprechenden Filterfrequenzen einstellbar.

Im mittleren Teil der Figur ist der Tuner 2 zu sehen, welchem die drei bandpassgefilterten HF-Rundfunksignale zugeführt werden. Die drei bandpassgefilterten HF-Rundfunksignale werden jeweils mittels eines im IC enthaltenen Mischers auf eine IF- oder Zwischenfrequenz herabgesetzt und dann intern zusammengeführt. Dieses Mischerausgangssignal ZFI steht nach einer weiteren internen Filterung mittels außenseitig angeschlossenem Filter 9 (Bandpass) dann als ZF-Signal ZF am Ausgang des Tuners 2 zur Verfügung. Nach einer weiteren spektralen Filterung, vorzugsweise mittels Oberflächenwellenfilter 25a-25c, gelangt dieses Signal zur ZF-Stufe 3.

Die ZF-Stufe 3 verarbeitet das aufgeteilte ZF-Signal so, dass dieses am Ausgang als Audiosignal AO, Datensignal DO oder als Videosignal VO, insbesondere als das FBAS-Signal, zur Verfügung steht. Diese werden innerhalb des Empfangsgeräts zur Bild- und Tonaufbereitung weitergeleitet.

Der Tuner 2 und die ZF-Stufe 3 weisen je eine mit den HF-Verstärkern 7a-7c verbundene automatische Verstärkungsregeleinheit 21, 31 auf. Die beiden Einheiten 21, 31 sind über eine gemeinsame Leitung 15 verbunden, die auch mit dem spannungsgesteuerten Eingang jedes der HF-Transistoren 7a-7c verbunden ist. Beide automatischen Verstärkungsregeleinheiten 21, 31 können mittels eines Regelsignals TAGC auf die HF-Transistoren 7a-7c regeln, so dass ein konstantes Ausgangssignal am Ausgang des Tuner 2 bzw. am Ausgang der ZF-Stufe 3 ansteht. Von der ZF-Stufe 3 kann ein Übernahmesignal AKT (Aktiv) an die angeschlossene Controlereinheit 10, um zu signalisieren, dass der Tuner 2 geregelt wird. Dies ist dann der Fall, wenn das ZF-Stufeneingangssignal einen definierten Pegel übersteigt. In diesem Fall übernimmt dann der Tuner 2 die Regelung. Im Beispiel der Figur weisen sowohl der Tuner 2 als auch die ZF-Stufe 3 eine serielle I²C-Busschnittstelle 32, 22 auf, so dass über eine Datenverbindungsleitung 14 das Übernahmesignals AKT von der ZF-Stufe 3 in Form von Daten DAT an den Tuner 2 übertragen werden kann.

Erfindungsgemäß ist vom Tuner 2 nun das ZF-Signal ZF mit einem vorgebbaren Pegelbegrenzungswert LIM erzeugbar, welcher zugleich als Referenz für einen Abgleich der automatischen Verstärkungsregeleinheit 31 der ZF-Stufe 3 dient.

Der Ausgangspegel des ZF-Signals ZF des Tuners 2 kann z.B. auf einen Pegelbegrenzungswert LIM von 106 dBµV eingestellt werden. Diesen Regelsollwert empfängt der Tuner 2 gleichfalls über die serielle Schnittstelle 22. Der Regelsollwert wird bausteinintern gespeichert, solange dieser mit Strom versorgt wird.

Im rechten Teil der Figur ist eine Steuereinheit 10 mit der Bezeichnung CONTROL zu sehen. Diese Steuereinheit 10 weist als Busmaster gleichfalls eine I²C-Busschnittstelle 12 auf. Neben einer Vielzahl nicht weiter dargestellter Busteilnehmer TN ist diese auch mit dem Tuner 2 und mit der ZF-Stufe 3 datentechnisch verbunden. Die Steuereinheit 10 ist z.B. ein Mikrocontroller, der u.a. auch einen nichtflüchtigen Speicher MEM zur Speicherung der Parameter sowie zur Speicherung des in der Steuereinheit 10 hinterlegten Steuerprogramms für das Empfangsgerät aufweist.

Wird z.B. von einem Benutzer ein Abgleichsvorgang zur Einstellung der automatischen Verstärkungsregeleinheit 31 der ZF-Stufe 3 durchgeführt, so stellt dies die Steuereinheit 10 fest und startet hierzu eine interne Softwareroutine. Die Steuereinheit 10 kann zuerst einen Tunerübernahmewert TOP mit einem hohen Pegelwert über den seriellen Bus an die ZF-Stufe 3 senden. In diesem Fall gibt die ZF-Stufe 3 über den seriellen Bus das Signal AKT als "AGC nicht aktiv" aus, d.h. in diesem Fall ist die automatische Verstärkungsregeleinheit 21 des Tuners 2 aktiv, der nun auch das pegelbegrenzte ZF-Signal ZF als Referenz erzeugt. Der an die ZF-Stufe 3 übertragene Tunerübernahmewert TOP wird in einem Register 33 der ZF-Stufe 3 gepuffert. Ein zum gepufferten Tunerübernahmewert TOP abgeleitetes analoges Steuersignal wirkt nun auf die automatische Verstärkungsregeleinheit 31 ein. Nachfolgend gibt die Steuereinheit 10 einen schrittweise abgesenkten Tunerübernahmewert TOP über den seriellen Bus an die ZF-Stufe 3 solange aus, bis eine Pegelvergleichsschaltung in der ZF-Stufe 3 umschaltet und das Signal AKT als "ACG aktiv" ausgibt. Ab diesem Zeitpunkt übernimmt die automatische Verstärkungsregeleinheit 31 der ZF-Stufe 3 die Verstärkungsregelung. Die Steuereinheit 10 erkennt nun den Wechsel des Signals AKT und speichert den zuletzt eingestellten Tunerübernahmewert TOP dauerhaft im nichtflüchtigen Speicher MEM. Dieser Wert kann dann bei einem Kanalwechsel oder bei Einschalten des Empfangsgeräts ausgelesen und als "Default"-Wert zur Einstellung der automatischen Verstärkungsregeleinheit 31 der ZF-Stufe herangezogen werden.

### Bezugszeichenliste

- 2: Tuner
- 3: ZF-Stufe
- 4: Eingangsbuchse
- 5: Hochpassfilter
- 6a-6c: Filtervorkreise
- 7a-7c: HF-Verstärker, Dual-Gate-MOSFET-Transistor
- 8a-8c: Bandpassfilter
- 9: 1. ZF-Filter nach dem Mischer
- 10: Steuereinheit
- 12, 22, 32: Schnittstelle, I²C-Schnittstelle
- 13: nichtflüchtiger Speicher
- 14: Busverbindungsleitung
- 15: Verbindungsleitung
- 21, 31: automatische Verstärkungsregeleinheit
- 33: Register
- AKT: Übernahmesignal
- AO: Audiosignal
- DAT: Daten
- DO: Datensignal
- LIM: Pegelbegrenzungswert
- RF: HF-Rundfunksignal
- TAGC: Regelsignal
- TN: Busteilnehmer
- VO: Videosignal, FBAS-Signal
- ZF: Zwischenfrequenzsignal, ZF-Signal
- ZFI: Mischerausgangssignal

## Patentansprüche

1. Empfängerschaltung für ein nachrichtentechnisches Empfangsgerät, mit zumindest einem HF-Verstärker (7a-7c) zur einstellbaren Verstärkung eines Rundfunksignals (4), mit einem Tuner (2) und einer ZF-Stufe (3), wobei der Tuner (2) und die ZF-Stufe (3) je eine mit dem zumindest einen HF-Verstärker (7a-7c) verbundene automatische Verstärkungsregeleinheit (21, 31) aufweisen, wobei von der ZF-Stufe (3) ein Übernahmesignal (AKT) an den Tuner (2) zur Übernahme der Verstärkungsregelung und ein Datensignal (DAT) an eine Steuereinheit (10) ausgebbar ist, wenn der Tuner (2) die Regelung übernimmt, wobei vom Tuner (2) ein ZF-Signal (ZF) mit einem vorgebbaren Pegelbegrenzungswert (LIM) erzeugbar ist, **dadurch gekennzeichnet, dass** das pegelbegrenzte ZF-Signal (ZF) zugleich als Referenz für einen Abgleich der automatischen Verstärkungsregeleinheit (31) der nachgeschalteten ZF-Stufe (3) dient.

2. Empfängerschaltung nach Anspruch 1, **dadurch gekennzeichnet, dass** der Tuner (2) und die ZF-Stufe (3) mit der Steuereinheit (10) verbunden sind, welche Mittel (12) zur Weiterleitung des Übernahmesignals (AKT) an den Tuner (2) und Mittel (12) zur Ausgabe eines Tunerübernahmewerts (TOP) an die ZF-Stufe (3) aufweist, wobei die Steuereinheit (10) den Tunerübernahmewert (TOP) solange erhöht bzw. erniedrigt, bis ein Wechsel des Übernahmesignals (AKT) detektierbar ist.

3. Empfängerschaltung nach einem der vorangegangenen Ansprüche, **dadurch gekennzeichnet, dass** der Pegelbegrenzungswert in einem Bereich von 103 dB□V bis 109 dB□V liegt.

4. Empfängerschaltung nach Anspruch 2 oder 3, **dadurch gekennzeichnet, dass** das Übernahmesignal (AKT) und der Tunerübernahmewert (TOP) über eine serielle Schnittstelle, insbesondere über eine I²C-Busschnittstelle (12, 22, 32), übertragbar sind.

5. Empfängerschaltung nach einem der Ansprüche 2 bis 4, **dadurch gekennzeichnet, dass** der Pegelbegrenzungswert (LIM) und der Tunerübernahmewert (TOP) in einem elektronischen Speicher (MEM), insbesondere in einem nichtflüchtigen EEPROM-Speicher, der Steuereinheit (10) speicherbar sind.

6. Empfängerschaltung nach einem der vorangegangenen Ansprüche, **dadurch gekennzeichnet, dass** der Pegelbegrenzungswert (LIM) über ein Benutzereingabemittel des Empfangsgeräts einstellbar ist.

7. Empfängerschaltung nach Anspruch 6, **dadurch gekennzeichnet, dass** das Benutzereingabemittel eine Fernbedienung ist.

8. Empfängerschaltung nach Anspruch 6 oder 7, **dadurch gekennzeichnet, dass** der Pegelbegrenzungswert (LIM) über ein Onscreen-Menue des Empfangsgeräts einstellbar ist.

9. Nachrichtentechnisches Empfangsgerät, insbesondere Fernsehgerät, mit einer Empfängerschaltung nach einem der vorangegangenen Ansprüche.

10. Verfahren zum Abgleich einer automatischen Verstärkungsregeleinheit (31) einer ZF-Stufe (3) einer Empfängerschaltung für ein nachrichtentechnisches Empfangsgerät, wobei die ZF-Stufe (3) einem Tuner (2) mit einer weiteren automatischen Verstärkungsregeleinheit (21) nachgeschaltet ist, wobei die ZF-Stufe (3) ein Übernahmesignal zur Übernahme der Verstärkungsregelung (AGC) an den Tuner (2) und an eine Steuereinheit (10) (DAT) ausgeben kann und wobei der Tuner (2) ein ZF-Signal (ZF) mit einem vorgebbaren Pegelbegrenzungswert (LIM) aus dem Rundfunksignal (4) erzeugt, **dadurch gekennzeichnet, dass** das pegelbegrenzte ZF-Signal (ZF) als Referenz für den Abgleich dient.

11. Verfahren nach Anspruch 10, **dadurch gekennzeichnet, dass** ein Tunerübernahmewert (TOP) der ZF-Stufe (3), bei dem die Verstärkerregelung an den Tuner (2) übergeben wird, solange erhöht bzw. erniedrigt wird, bis ein Wechsel des Übernahmesignals (AKT) detektiert wird.

12. Verfahren nach Anspruch 11, **dadurch gekennzeichnet, dass** der Tunerübernahmewert (TOP) von einem Benutzer des Empfangsgeräts eingestellt werden kann.

13. Verfahren nach einem der Ansprüche 10 bis 12, **dadurch gekennzeichnet, dass** der Abgleich in vorgebbaren Zeitabständen und/oder bei einem Kanalwechsel automatisch erfolgt.

## Claims

1. Receiver circuit for a communications receiver, with at least one high-frequency amplifier (7a-7c) for settable amplification of a broadcast signal (4), with a tuner (2) and an intermediate-frequency stage (3), wherein the tuner (2) and the intermediate-frequency stage (3) each comprise an automatic amplification regulating unit (21, 31) connected with the at least one high-frequency amplifier (7a-7c), wherein a take-over signal (AKT) can be issued from the high-frequency stage (3) to the tuner (2) for taking over the amplification regulation and a data signal (DAT) to a control unit (10) when the tuner (2) takes over the regulation, wherein an intermediate-frequency signal (ZF) with a presettable level limiting value (LIM) can be generated by the tuner (2), **characterised in that** the level-limited intermediate-frequency signal (ZF) serves at the same time as reference for trimming the automatic amplification regulating unit (31) of the downstream intermediate-frequency stage (3).

2. Receiver circuit according to claim 1, **characterised in that** the tuner (2) and the intermediate-frequency stage (3) are connected with the control unit (10), which comprises means (12) for passing on the take-over signal (AKT) to the tuner (2) and means (12) for issue of a tuner take-over value (TOP) to the intermediate-frequency stage (3), wherein the control unit (10) increases or decreases the tuner take-over value (TOP) until a change in the take-over signal (AKT) is detectable.

3. Receiver circuit according to one of the preceding claims, **characterised idn that** the level limiting value-lies in a range of 103 dBµV to 109 dBµV.

4. Receiver circuit according to claim 2 or 3, **characterised in that** the take-over signal (AKT) and the tuner take-over value (TOP) are transmissible by way of a serial interface, particularly by way of an I²C bus interface (12, 22, 32).

5. Receiver circuit according to any one of claims 2 to 4, **characterised in that** the level limiting value (LIM) and the tuner take-over value (TOP) can be stored in an electronic memory (MEM), particularly in a non-volatile EEPROM memory, of the control unit (10).

6. Receiver circuit according to any one of the preceding claims, **characterised in that** the level limiting value (LIM) is settable by way of a user input means of the receiver.

7. Receiver circuit according to claim 6, **characterised in that** the user input means is a remote control.

8. Receiver circuit according to claim 6 or 7, **characterised in that** the level limiting value (LIM) is settable by way of an on-screen menu of the receiver.

9. Communications receiver, particularly television set, with a receiver according to any one of the preceding claims.

10. Method of trimming an automatic amplification regulator unit (31) of an intermediate-frequency stage (3) of a receiver circuit for a communications receiver, wherein the intermediate-frequency stage (3) is connected downstream of a tuner (2) with a further automatic amplification regulator unit (21), wherein the intermediate-frequency stage (3) can issue a take-over signal for taking over the amplification regulation (AGC) to the tuner (2) and to a control unit (10) (DAT) and wherein the tuner (2) generates an intermediate-frequency signal (ZF) with a presettable level limiting value (LIM) from the broadcast signal (4), **characterised in that** the level-limited intermediate-frequency signal (ZF) serves as reference for the trimming.

11. Method according to claim 10, **characterised in that** a tuner take-over value (TOP) of the intermediate-frequency stage (3) in which the amplification regulation is transferred to the tuner (2) is increased or decreased until a change in the take-over signal (AKT) is detected.

12. Method according to claim 11, **characterised in that** the tuner take-over value (TOP) can be set by a user of the receiver.

13. Method according to any one of claims 10 to 12, **characterised in that** the trimming is automatically carried out at presettable time intervals and/or on a change of channel.

## Revendications

1. Circuit de réception pour un appareil de réception utilisé dans le domaine de l'information, avec au moins un amplificateur HF (7a-7c) pour l'amplification réglable d'un signal radio (4), avec un tuner (2) et un étage FI (3), le tuner (2) et l'étage FI (3) présentant chacun une unité de réglage d'amplification (21, 31) automatique reliée audit au moins un amplificateur HF (7a-7c), l'étage FI (3) pouvant transmettre un signal de prise en charge (AKT) au tuner (2) pour la prise en charge du réglage d'amplification et un signal de données (DAT) à une unité de commande (10), lorsque le tuner (2) prend en charge le réglage, le tuner (2) pouvant générer un signal FI (ZF) avec une valeur de limitation de niveau (LIM) prédéfinissable, **caractérisé en ce que** le signal FI (ZF) à niveau limité sert aussi de référence à un ajustage de l'unité de réglage d'amplification (31) automatique de l'étage FI (3) placé en aval.

2. Circuit de réception selon la revendication 1, **caractérisé en ce que** le tuner (2) et l'étage FI (3) sont reliés à l'unité de commande (10), laquelle présente des moyens (12) de transmission du signal de prise en charge (AKT) au tuner (2) et des moyens (12) d'émission d'une valeur de prise en charge du tuner (TOP) à l'étage FI (3), l'unité de commande (10) augmentant, respectivement diminuant, la valeur de prise en charge du tuner (TOP) jusqu'à ce qu'un changement du signal de prise en charge (AKT) puisse être détecté.

3. Circuit de réception selon l'une quelconque des revendications précédentes, **caractérisé en ce que** la valeur de limitation de niveau se situe dans une plage allant de 103 dBµV à 109 dBµV.

4. Circuit de réception selon la revendication 2 ou 3, **caractérisé en ce que** le signal de prise en charge (AKT) et la valeur de prise en charge du tuner (TOP) sont transférables par le biais d'une interface sérielle, en particulier par le biais d'une interface bus I²C (12, 22, 32).

5. Circuit de réception selon l'une quelconque des revendications 2 à 4, **caractérisé en ce que** la valeur de limitation de niveau (LIM) et la valeur de prise en charge du tuner (TOP) sont enregistrables dans une mémoire électronique (MEM), en particulier dans une mémoire EEPROM non volatile, de l'unité de commande (10).

6. Circuit de réception selon l'une quelconque des revendications précédentes, **caractérisé en ce que** la valeur de limitation de niveau (LIM) est réglable par le biais d'un moyen de saisie de l'utilisateur de l'appareil de réception.

7. Circuit de réception selon la revendication 6, **caractérisé en ce que** le moyen de saisie de l'utilisateur est une télécommande.

8. Circuit de réception selon la revendication 6 ou 7, **caractérisé en ce que** la valeur de limitation de niveau (LIM) est réglable par le biais d'un menu à l'écran de l'appareil de réception.

9. Appareil de réception pour le domaine de l'information, en particulier appareil de télévision, avec un circuit de réception selon l'une quelconque des revendications précédentes.

10. Procédé d'ajustage d'une unité de réglage d'amplification (31) automatique d'un étage FI (3) d'un circuit de réception pour un appareil de réception utilisé dans le domaine de l'information, l'étage FI (3) étant placé en aval d'un tuner (2) avec une autre unité de réglage d'amplification (21) automatique, l'étage FI (3) pouvant transmettre un signal de prise en charge pour la prise en charge du réglage d'amplification (AGC) au tuner (2) et à une unité de commande (10) et le tuner (2) générant un signal FI (ZF) avec une valeur de limitation de niveau (LIM) prédéfinissable à partir d'un signal radio (4), **caractérisé en ce que** le signal FI (ZF) à niveau limité sert de référence à l'ajustage.

11. Procédé selon la revendication 10, **caractérisé en ce qu'**une valeur de prise en charge du tuner (TOP) de l'étage FI (3), dans lequel le réglage de l'amplificateur est transféré au tuner (2), est augmentée, respectivement diminuée, jusqu'à ce qu'un changement du signal de prise en charge (AKT) soit détecté.

12. Procédé selon la revendication 11, **caractérisé en ce que** la valeur de prise en charge du tuner (TOP) est réglable par un utilisateur de l'appareil de réception.

13. Procédé selon l'une quelconque des revendications 10 à 12, **caractérisé en ce que** l'ajustage se fait automatiquement à des intervalles de temps prédéfinissables et/ou lors d'un changement de canal.
